# FASCICULE DE BREVET EUROPEEN

(11) **EP 4 250 297 B1**
(45) Date de publication et mention de la délivrance du brevet: **21.08.2024**
(21) Numéro de dépôt: 23162745.6
(22) Date de dépôt: 17.03.2023
(51) Int. Cl.: G11C 17/16, H10B 20/00, H01L 23/525

(54) **MEMOIRE MORTE PROGRAMMABLE**
PROGRAMMIERBARER FESTWERTSPEICHER
PROGRAMMABLE READ ONLY MEMORY

(30) Priorité: 21.03.2022 FR 2202466
(43) Date de publication de la demande: 27.09.2023
(73) Titulaire: STMicroelectronics (Rousset) SAS, 13790 Rousset (FR)
(72) Inventeur: CALENZO, Patrick, 13124 PEYPIN (FR); MATTEI, Sandra, 13710 FUVEAU (FR)
(74) Mandataire: Cabinet Beaumont

(56) Documents cités:
- US-A1- 2005 104 117
- US-A1- 2014 217 490
- US-B1- 10 446 562
- US-B1- 6 201 282
- US-B1- 9 613 714

## Description

### Domaine technique

La présente description concerne de façon générale les cellules mémoire et plus précisément les cellules mémoire du type mémoire morte programmable.

### Technique antérieure

Une mémoire morte programmable (en anglais PROM pour Programmable Read Only Memory, ou OTP pour One Time Programmable) est un type de mémoire morte qui peut être programmée une seule fois.

Il existe plusieurs types de mémoires PROM dont un type dit fusible correspondant à des cellules mémoires dans lesquelles une couche isolante est endommagée par un claquage électrique. La cellule mémoire contient donc une première valeur binaire lorsque l'isolant n'est pas endommagé et une autre valeur binaire lorsque l'isolant est endommagé.

Le document US 2005/104117 divulgue un dispositif mémoire a piégeage de charge, fonctionnement et fabrication.

Le document US 6201282 divulgue cellule de mémoire morte à double bit et son procédé de fabrication.

Le document US 9613714 divulgue une cellule de mémoire à programmation unique et réseau de mémoire pour une technologie de fonction physiquement non clonable et procédé de génération de code aléatoire associé.

### Résumé de l'invention

Un mode de réalisation pallie tout ou partie des inconvénients des mémoires mortes programmables connues.

L'invention est définie par la revendication indépendante 1. Des modes de réalisation préférés sont définis par les revendications dépendantes.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente un mode de réalisation d'une cellule mémoire d'une mémoire morte programmable ; et
la figure 2 représente une vue du mode de réalisation de la figure 1 dans le plan B-B de la figure 1 ; et
la figure 3 est une vue du mode de réalisation de la figure 1 dans le plan B-B de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

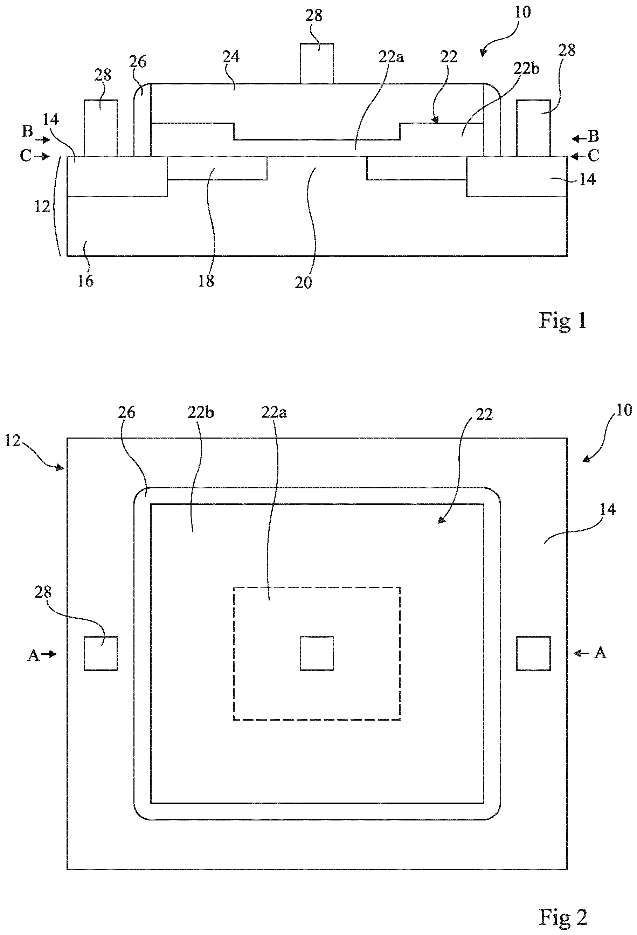

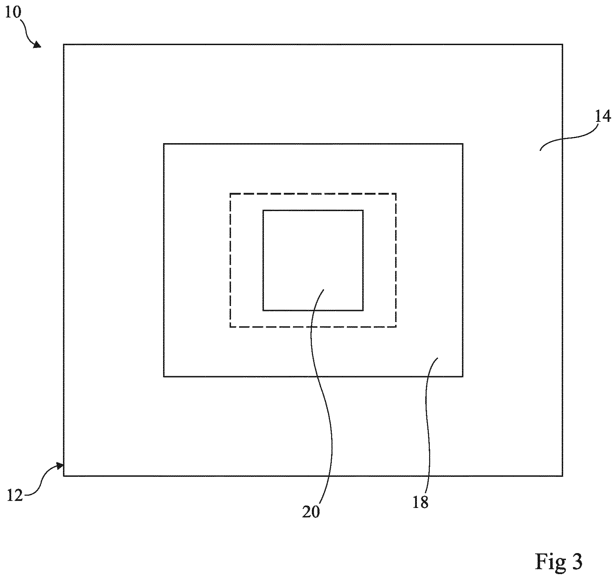

La figure 1 représente un mode de réalisation d'une cellule mémoire 10 d'une mémoire morte programmable. La figure 2 représente une vue du mode de réalisation de la figure 1 selon le plan B-B de la figure 1. La figure 1 est une vue en coupe de la cellule mémoire 10 d'une mémoire morte programmable selon le plan A-A de la figure 2. La figure 3 est une vue dans le plan C-C de la figure 1.

La cellule 10 est formée dans et sur un caisson 12. Le caisson 12 est en un matériau semiconducteur, par exemple en silicium. Le caisson 12 est dopé d'un premier type de conductivité, par exemple de type N. Le caisson 12 est par exemple dans un substrat massif, par exemple dopé d'un même type de conductivité que le caisson 12. Alternativement, le caisson 12 est formé dans un substrat de type semiconducteur sur isolant (SOI - Semiconductor On Insulator).

Le caisson 12 comprend une région 14. La région 14 est une région fortement dopée du premier type de conductivité. Autrement dit, la région 12 est une région dopée du même type de dopage que le caisson 12. La hauteur de la région 14 est inférieure à la hauteur du caisson 12. La région 14 affleure une face supérieure du caisson 12. La figure 3 correspond à une vue dans le plan de la face supérieure du caisson 12. La région 14 y est donc visible.

La région 14 repose sur une région 16 du caisson. La région 14 est plus fortement dopée que la région 16. Par exemple, la concentration en dopants dans la région 14 est au moins dix fois plus importante que la concentration en dopants dans la région 16. La région 14 est située dans toute la périphérie du caisson 12. La région 14 forme donc un contour fermé.

Le caisson 12 comprend une région 18. La région 18 est une région dopée du même type de conductivité que la région 14 et la région 16. La région 18 est plus fortement dopée que la région 16, par exemple au moins deux fois plus dopée. Autrement dit, la concentration en dopants dans la région 18 est au moins deux fois supérieure à la concentration en dopants dans la région 16. La région 18 est par exemple moins fortement dopée que la région 14.

La région 18 affleure la face supérieure du caisson 12. La région 18 a une épaisseur inférieure à l'épaisseur de la région 14. La région 18 repose sur la région 16.

La région 18 est située à l'intérieur du contour formé par la région 14. La région 18 est ainsi entourée par la région 14. La région 18 est en contact latéral avec la région 14. Par exemple, le contact, ou interface, entre les régions 14 et 18 entoure entièrement la région 18.

La région 18 entoure par exemple une région 20. La région 20 affleure la face supérieure du caisson 12. La région 20 est une portion de la région 16 et est de préférence en contact avec les portions de la région 16 sur lesquelles les régions 14 et 18 reposent. La région 20 est plus faiblement dopée que les régions 14 et 18. Par exemple, la région 20 est au moins deux fois moins dopée que la région 18. Autrement dit, la concentration en dopants de la région 20 est inférieure, par exemple au moins deux fois plus faible, que la concentration en dopants de la région 18. La concentration en dopants de la région 20 est par exemple sensiblement égale à la concentration en dopants du reste de la région 16.

La cellule mémoire 10 comprend une couche isolante 22, par exemple en un oxyde, par exemple en oxyde de silicium. La couche 22 repose sur le caisson 12. La couche 22 recouvre entièrement la région 20. La couche 22 recouvre au moins partiellement, de préférence entièrement la région 18. La couche 22 recouvre par exemple partiellement la région 14.

La couche 22 comprend une première partie, ou partie centrale, 22a et une deuxième partie, ou partie périphérique, 22b. La couche 22 comprend de préférence uniquement les première et deuxième parties. La séparation entre les parties 22a et 22b est représentée en pointillés dans les figures 2 et 3. La partie 22a est entourée, de préférence entièrement, par la partie 22b dans un plan parallèle à la face supérieure du caisson 12.

Ainsi, dans le mode de réalisation des figures 1 à 3, la partie 22b forme un anneau autour de la partie 22a. La couche 22 comprend ainsi une unique partie 22a et une unique partie 22b.

Alternativement, la couche 22 peut comprendre deux parties 22b s'étendant le long de côtés opposés de la partie 22a. Les parties 22b sont alors séparées l'une de l'autre par la partie 22a. Les parties 22b sont en contact avec les côtés de la partie 22a.

La partie 22a a une épaisseur inférieure à l'épaisseur de la partie 22b. De préférence, l'épaisseur de la partie 22b est au moins une fois et demi plus élevée que l'épaisseur de la partie 22a, par exemple au moins deux fois plus élevée. L'épaisseur de la partie 22a est de préférence constante. De même, l'épaisseur de la partie 22b est de préférence constante.

Les parties 22a et 22b ont de préférence une face inférieure commune et plane. Ladite face inférieure est de préférence en contact avec le caisson 12. Les faces supérieures des parties 22a et 22b, c'est-à-dire les faces opposées à la face inférieure, sont de préférence parallèles entre elles.

La partie 22a recouvre de préférence entièrement la région 20. La partie 22a recouvre au moins partiellement, de préférence partiellement, la région 18. La région 18 est en contact avec toute une portion périphérique de la partie 22a, plus précisément avec la face inférieure de la portion périphérique de la couche 22. La région 22b recouvre par exemple partiellement la région 18. La région 22b recouvre par exemple entièrement la portion périphérique de la région 18. La région 18 est par exemple recouverte entièrement par la partie 22a et la partie 22b. La partie 22a repose de préférence uniquement sur les régions 18 et 20. La partie 22b recouvre par exemple partiellement la région 14. De préférence, au moins une partie de la région 14 n'est pas recouverte par la couche 22.

La couche 22 est recouverte, de préférence entièrement, par une couche 24. La couche 24 est en un matériau conducteur ou semiconducteur, par exemple en silicium polycristallin. La couche 24 recouvre de préférence uniquement la couche 24. Ainsi, les parois latérales de la couche 24 sont par exemple coplanaires aves les parois latérales de la couche 22, c'est-à-dire les parois latérales de la partie 22b. La couche 24 est par exemple en contact avec toute la face supérieure de la couche 24. La couche 24 est séparée du caisson 12 par la couche 22. Ainsi, la couche 24 n'est pas en contact avec le caisson 12.

La cellule 10 comprend en outre des espaceurs 26 recouvrant les parois latérales des couches 22 et 14. Les espaceurs recouvrent de préférence toutes les parois latérales des couches 22 et 24. De préférence, au moins une partie de la région 14 n'est pas recouverte par la couche 22 ou les espaceurs 26.

La cellule 10 comprend des vias conducteurs, ou contacts, 28. La région 14 est en contact avec au moins un via 28. Dans l'exemple des figures 1 à 3, la région 14 est en contact avec deux vias 28. La couche 24 est en contact avec au moins un via 28, par exemple un unique via 28.

De préférence, la distance entre deux points de la partie 22b séparés par la partie 22a est au moins égale à 1,5 µm. Par exemple, la distance entre deux points de la région 18 séparés par la partie 20 est au moins égale à 0,5 µm. Ainsi, la plus petite dimension, dans le plan de la face supérieure du caisson 12, de la portion de la partie 22a en regard de la région 18 est par exemple au moins égale à 0,5 µm. Le rapport entre la largeur de la partie 22b et la largeur de la partie 22a est par exemple supérieure ou égale à 2. Autrement dit, la largeur de la partie 22b est au moins deux fois supérieure à la largeur de la partie 22a. Par largeur de la partie 22b, on entend la distance entre la paroi latérale extérieure de la partie 22b, c'est-à-dire la paroi latérale la plus éloignée de la partie 22a et la paroi latérale interne, c'est-à-dire l'interface entre les parties 22a et 22b. Par largeur de la partie 22a, on entend la distance entre deux parois latérales de la partie 22a dans le plan dans lequel la largeur de la partie 22b est mesurée.

Lors d'une étape de programmation de la cellule mémoire, un courant traverse la cellule entre la couche 24 et la région 14, en passant par la couche 22 et la région 18. La valeur du courant est suffisamment importante pour faire craquer, ou casser, le matériau de la couche 22, c'est-à-dire l'endommager, de préférence uniquement en un emplacement. Ainsi, audit emplacement, le matériau de la couche 22 n'est plus isolant électriquement.

De manière à déterminer la donnée mémorisée par la cellule, on détermine par exemple la résistance entre la couche 24 et la région 14. La cellule mémoire est considérée comme mémorisant une première valeur binaire si la résistance est élevée, par exemple supérieure à un seuil, ce qui correspond au cas où le matériau de la couche 22 n'a pas été craqué, et une deuxième valeur binaire si la résistance est faible, par exemple inférieure au seuil, ce qui correspond au cas où le matériau de la couche 22 a été craqué.

Dans le mode de réalisation des figures 1 à 3, la cassure dans le matériau de la couche 22 apparait dans la portion de la partie 22a en regard de la région 18. En effet, la cassure apparait sur le chemin le plus accessible au courant, c'est-à-dire le chemin le moins résistif. Le chemin traversant la portion de la partie 22a en regard de la région 20 a une résistance supérieure à celle du chemin traversant la portion de la partie 22a en regard de la région 18, la région 20 étant moins dopée que la région 18. Le chemin traversant la portion de la partie 22b en regard de la région 18 ou de la région 14 a une résistance supérieure à celle du chemin traversant la portion de la partie 22a en regard de la région 18, la partie 22b étant plus épaisse que la partie 22a.

Il est donc possible de prévoir l'emplacement de la cassure. De plus, l'emplacement est sensiblement dans la même portion de la couche 22 quelle que soit la cellule mémoire.

On aurait pu choisir de former une couche 22 plane, c'est-à-dire ayant une épaisseur constante sur l'ensemble de sa surface. Cependant, il n'aurait pas été possible de prévoir l'emplacement de la cassure. Les cassures pourraient alors être situées à des endroits différents de la couche d'isolant, ce qui entraînerait une variabilité d'une cellule à une autre dans la valeur de seuil entre les première et deuxième valeurs binaires.

De plus, durant le procédé de fabrication de la cellule, diverses étapes peuvent endommager la couche 22, et plus particulièrement la périphérie de la couche 22. Par exemple, les étapes pouvant entraîner des dommages à la couche 22 incluent les étapes de dopages du substrat, la formation des espaceurs, la gravure de la couche 24, etc. Les dommages causés ne sont pas identiques dans toutes les cellules mémoire. Ainsi, si la couche 22 est une couche plane, les cassures peuvent se produire dans la périphérie de la couche 22 et entraîner des variations de valeur de seuil.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que les régions 14, 18, 20 et les couches 22, 24 aient en vue de dessus des formes sensiblement rectangulaires, il est bien entendu que les régions 14, 18, 20 et les couches 22, 24 pourraient avoir, en vue de dessus, d'autres formes, par exemple des formes circulaires, ovales ou des formes de quadrilatères aux angles arrondis.

Enfin, la mise en oeuvre pratique des modes de réalisation et variantes décrits est à la portée de la personne du métier à partir des indications fonctionnelles données ci-dessus.

## Revendications

1. Cellule mémoire morte programmable (10) comprenant une première couche isolante (22) située entre un caisson semiconducteur (12) et une deuxième couche conductrice ou semiconductrice (24), la première couche isolante (22) comprenant une partie périphérique (22b) et une partie centrale (22a), la partie périphérique (22b) ayant une épaisseur supérieure à l'épaisseur de la partie centrale (22a), étant **caractérisée en ce que** le caisson (12) comprenant des première (16) et deuxième (18) régions, la deuxième région (18) étant plus fortement dopée que la première région (16), la partie centrale (22a) étant en contact avec la deuxième région (18).

2. Cellule mémoire morte programmable selon la revendication 1, dans laquelle le caisson (12) est en contact avec la première couche (22) et la deuxième couche (24) est en contact avec la première couche (22).

3. Cellule mémoire morte programmable selon la revendication 1 ou 2, dans laquelle le caisson (12) et la deuxième couche (24) ne sont pas en contact.

4. Cellule mémoire morte programmable selon l'une quelconque des revendications 1 à 3, dans laquelle les épaisseurs des parties centrale (22a) et périphérique (22b) de la première couche (22) sont sensiblement constantes.

5. Cellule mémoire morte programmable selon l'une quelconque des revendications 1 à 4, dans laquelle l'épaisseur de la partie périphérique (22b) de la première couche (22) est au moins une fois et demi plus élevée que l'épaisseur de la partie centrale (22a) de la première couche (22).

6. Cellule mémoire morte programmable selon l'une quelconque des revendications 1 à 5, dans laquelle la deuxième région (18) entoure une portion (20) de la première région (16), la partie centrale (22a) reposant uniquement sur la deuxième région (18) et sur ladite portion (20) de la première région (16).

7. Cellule mémoire morte programmable selon l'une quelconque des revendications 1 à 6, dans laquelle une portion périphérique de la deuxième région (18) est recouverte par la partie périphérique (22b).

8. Cellule mémoire morte programmable selon l'une quelconque des revendications 1 à 7, dans laquelle la portion de la deuxième région (18) n'étant pas recouverte par la partie centrale (22a) est recouverte par la partie périphérique (22b).

9. Cellule mémoire morte programmable selon l'une quelconque des revendications 1 à 8, dans laquelle la concentration de dopants de la deuxième région (18) est au moins deux fois supérieure à celle de la première région (16).

10. Cellule mémoire morte programmable selon l'une quelconque des revendications 1 à 9, dans laquelle la plus petite dimension, dans le plan de la face supérieure du caisson (12), de la portion de la partie centrale (22a) de la première couche (22) située en regard de la deuxième région (18) est au moins égale à 0,5 µm.

11. Cellule mémoire morte programmable selon l'une quelconque des revendications 1 à 10, dans laquelle le caisson (12) comprend une troisième région (14), plus fortement dopée que la deuxième région (18), entourant la deuxième région (18) et comprenant au moins une portion non recouverte par la première couche (22) .

12. Cellule mémoire morte programmable selon la revendication 11, comprenant au moins un contact conducteur (28) en contact avec la troisième région (14).

13. Cellule mémoire morte programmable selon l'une quelconque des revendications 1 à 12, dans laquelle le rapport entre la largeur de la partie périphérique (22b) et la partie centrale (22a) est supérieure ou égale à 2.

14. Cellule mémoire morte programmable selon l'une quelconque des revendications 1 à 13, dans laquelle la deuxième couche (24) recouvre uniquement la première couche (22).

## Patentansprüche

1. Programmierbare Festwertspeicherzelle (10) aufweisend eine erste Isolierschicht (22), die zwischen einem Halbleiterkörper (12) und einer zweiten Leiter- oder Halbleiterschicht (24) angeordnet ist, wobei die erste Isolierschicht (22) einen Umfangsteil (22b) und einen Mittelteil (22a) aufweist, wobei der Umfangsteil (22b) eine Dicke aufweist, die größer ist als die Dicke des Mittelteils (22a), **dadurch gekennzeichnet, dass** der Körper (12) einen ersten (16) und einen zweiten (18) Bereich aufweist, wobei der zweite Bereich (18) stärker dotiert ist als der erste Bereich (16), wobei der Mittelteil (22a) in Kontakt mit dem zweiten Bereich (18) steht.

2. Programmierbare Festwertspeicherzelle nach Anspruch 1, wobei der Körper (12) in Kontakt mit der ersten Schicht (22) und die zweite Schicht (24) in Kontakt mit der ersten Schicht (22) ist.

3. Programmierbare Festwertspeicherzelle nach Anspruch 1 oder 2, wobei der Körper (12) und die zweite Schicht (24) nicht in Kontakt sind.

4. Programmierbare Festwertspeicherzelle nach einem der Ansprüche 1 bis 3, wobei die Dicken des Mittelteils (22a) und des Umfangsteils (22b) der ersten Schicht (22) im Wesentlichen konstant sind.

5. Programmierbare Festwertspeicherzelle nach einem der Ansprüche 1 bis 4, wobei die Dicke des Umfangsteils (22b) der ersten Schicht (22) mindestens eineinhalbmal größer ist als die Dicke des Mittelteils (22a) der ersten Schicht (22).

6. Programmierbare Festwertspeicherzelle nach einem der Ansprüche 1 bis 5, wobei der zweite Bereich (18) einen Teil (20) des ersten Bereichs (16) umgibt, wobei der Mittelteil (22a) nur auf dem zweiten Bereich (18) und auf dem Teil (20) des ersten Bereichs (16) aufliegt.

7. Programmierbare Festwertspeicherzelle nach einem der Ansprüche 1 bis 6, wobei ein Umfangsteil des zweiten Bereichs (18) mit dem Umfangsteil (22b) bedeckt ist.

8. Programmierbare Festwertspeicherzelle nach einem der Ansprüche 1 bis 7, wobei der Teil des zweiten Bereichs (18), der nicht mit dem Mittelteil (22a) bedeckt ist, mit dem Umfangsteil (22b) bedeckt ist.

9. Programmierbare Festwertspeicherzelle nach einem der Ansprüche 1 bis 8, wobei die Dotierstoffkonzentration des zweiten Bereichs (18) mindestens doppelt so hoch wie die des ersten Bereichs (16) ist.

10. Programmierbare Festwertspeicherzelle nach einem der Ansprüche 1 bis 9, wobei die kleinste Abmessung in der Ebene der Oberseite des Körpers (12) des Teils des Mittelteils (22a) der ersten Schicht (22), der dem zweiten Bereich (18) gegenüberliegt, mindestens gleich 0,5 µm ist.

11. Programmierbare Festwertspeicherzelle nach einem der Ansprüche 1 bis 10, wobei der Körper (12) einen dritten Bereich (14) aufweist, der stärker dotiert ist als der zweite Bereich (18), der den zweiten Bereich (18) umgibt und mindestens einen Teil aufweist, der nicht mit der ersten Schicht (22) bedeckt ist.

12. Programmierbare Festwertspeicherzelle nach Anspruch 11, die mindestens einen leitenden Kontakt (28) in Kontakt mit dem dritten Bereich (14) aufweist.

13. Programmierbare Festwertspeicherzelle nach einem der Ansprüche 1 bis 12, wobei das Verhältnis zwischen der Breite des Umfangsteils (22b) und des Mittelteils (22a) größer als oder gleich 2 ist.

14. Programmierbare Festwertspeicherzelle nach einem der Ansprüche 1 bis 13 , wobei die zweite Schicht (24) nur die erste Schicht (22) bedeckt.

## Claims

1. Programmable read-only memory cell (10) comprising a first insulating layer (22) located between a semiconductor body (12) and a second conductor or semiconductor layer (24), the first insulating layer (22) comprising a peripheral portion (22b) and a central portion (22a), the peripheral portion (22b) having a thickness greater than the thickness of the central portion (22a), **characterized in that** the body (12) comprises first (16) and second (18) regions, the second region (18) being more heavily doped than the first region (16), the central portion (22a) being in contact with the second region (18).

2. Programmable read-only memory cell according to claim 1, wherein the body (12) is in contact with the first layer (22) and the second layer (24) is in contact with the first layer (22).

3. Programmable read-only memory cell according to claim 1 or 2, wherein the body (12) and the second layer (24) are not in contact.

4. Programmable read-only memory cell according to any of claims 1 to 3, wherein the thicknesses of the central (22a) and peripheral (22b) portions of the first layer (22) are substantially constant.

5. Programmable read-only memory cell according to any of claims 1 to 4, wherein the thickness of the peripheral portion (22b) of the first layer (22) is at least one and a half time greater than the thickness of the central portion (22a) of the first layer (22).

6. Programmable read-only memory cell according to any of claims 1 to 5, wherein the second region (18) surrounds a portion (20) of the first region (16), the central portion (22a) only resting on the second region (18) and on said portion (20) of the first region (16).

7. Programmable read-only memory cell according to any of claims 1 to 6, wherein a peripheral portion of the second region (18) is covered with the peripheral portion (22b).

8. Programmable read-only memory cell according to any of claims 1 to 7, wherein the portion of the second region (18) which is not covered with the central portion (22a) is covered with the peripheral portion (22b).

9. Programmable read-only memory cell according to any of claims 1 to 8, wherein the dopant concentration of the second region (18) is at least twice greater than that of the first region (16).

10. Programmable read-only memory cell according to any of claims 1 to 9, wherein the smallest dimension, in the plane of the upper surface of the body (12), of the portion of the central portion (22a) of the first layer (22) located opposite the second region (18) is at least equal to 0.5 µm.

11. Programmable read-only memory cell according to any of claims 1 to 10, wherein the body (12) comprises a third region (14), more heavily doped than the second region (18), surrounding the second region (18) and comprising at least a portion which is not covered with the first layer (22).

12. Programmable read-only memory cell according to claim 11, comprising at least one conductive contact (28) in contact with the third region (14).

13. Programmable read-only memory cell according to any of claims 1 to 12, wherein the ratio between the width of the peripheral portion (22b) and the central portion (22a) is greater than or equal to 2.

14. Programmable read-only memory cell according to any of claims 1 to 13, wherein the second layer (24) only covers the first layer (22).
